# FASCICULE DE BREVET EUROPEEN

(11) **EP 3 494 420 B1**
(45) Date de publication et mention de la délivrance du brevet: **11.10.2023**
(21) Numéro de dépôt: 17764873.0
(22) Date de dépôt: 02.08.2017
(51) Int. Cl.: G02B 5/08, G02B 5/26, G02B 5/28

(54) **SUBSTRAT MUNI D'UN EMPILEMENT A PROPRIETES THERMIQUES COMPORTANT AU MOINS UNE COUCHE COMPRENANT DU NITRURE DE SILICIUM-ZIRCONIUM ENRICHI EN ZIRCONIUM, SON UTILISATION ET SA FABRICATION**
SUBSTRAT MIT EINEM STAPEL MIT THERMISCHEN EIGENSCHAFTEN MIT MINDESTENS EINER SCHICHT MIT ZIRKONIUMREICHEM SILICIUM-ZIRKONIUM-NITRID, VERWENDUNG UND HERSTELLUNG DAVON
SUBSTRATE EQUIPPED WITH A STACK WITH THERMAL PROPERTIES INCLUDING AT LEAST ONE LAYER COMPRISING ZIRCONIUM-RICH SILICON-ZIRCONIUM NITRIDE, USE AND MANUFACTURE THEREOF

(30) Priorité: 02.08.2016 FR 1657497
(43) Date de publication de la demande: 12.06.2019
(73) Titulaire: SAINT-GOBAIN GLASS FRANCE, 92400 Courbevoie (FR)
(72) Inventeur: MERCADIER, Nicolas, 75014 Paris (FR); ORVEN, Matthieu, 92230 Gennevilliers (FR); CAILLET, Xavier, 94120 Fontenay Sous Bois (FR); BILLIERES, Dominique, 84450 Saint-saturnin Les Avignon (FR)
(74) Mandataire: Saint-Gobain Recherche
(86) Numéro de dépôt international: PCT/FR2017/052166
(87) Numéro de publication internationale: WO 2018/024985

(56) Documents cités:
- EP-A1- 0 560 534
- EP-A1- 1 463 689
- EP-A1- 2 338 851
- EP-B1- 1 463 689
- WO-A1-2012/127162
- WO-A1-2017/006029
- FR-A1- 2 858 816
- FR-A1- 2 919 114
- FR-A1- 2 919 429
- US-A1- 2014 319 116

## Description

L'invention concerne un substrat transparent notamment en un matériau rigide minéral comme le verre, ledit substrat étant revêtu d'un empilement de couches minces comprenant une couche fonctionnelle de type métallique pouvant agir sur le rayonnement solaire et/ou le rayonnement infrarouge de grande longueur d'onde.

L'invention concerne plus particulièrement l'utilisation de tels substrats pour fabriquer des vitrages d'isolation thermique et/ou de protection solaire. Ces vitrages peuvent être destinés aussi bien à équiper les bâtiments que les véhicules, en vue notamment de diminuer l'effort de climatisation et/ou d'empêcher une surchauffe excessive (vitrages dits « de contrôle solaire ») et/ou diminuer la quantité d'énergie dissipée vers l'extérieur (vitrages dits « bas émissifs ») entraînée par l'importance toujours croissante des surfaces vitrées dans les bâtiments et les habitacles de véhicules.

Ces vitrages peuvent par ailleurs être intégrés dans des vitrages présentant des fonctionnalités particulières, comme par exemple des vitrages chauffants ou des vitrages électrochromes.

Un type d'empilement de couches connu pour conférer aux substrats de telles propriétés comporte une couche métallique fonctionnelle à propriétés de réflexion dans l'infrarouge et/ou dans le rayonnement solaire, notamment une couche fonctionnelle métallique à base d'argent ou d'alliage métallique contenant de l'argent.

Dans ce type d'empilement, la couche fonctionnelle se trouve disposée entre deux revêtements antireflets comportant chacun en général plusieurs couches qui sont chacune en un matériau diélectrique du type nitrure et notamment nitrure de silicium ou d'aluminium ou du type oxyde. Du point de vue optique, le but de ces revêtements qui encadrent la couche fonctionnelle métallique est « d'antirefléter » cette couche fonctionnelle métallique.

Un revêtement de blocage est toutefois intercalé parfois entre un ou chaque revêtement antireflet et la couche métallique fonctionnelle : un revêtement de blocage disposé sous la couche fonctionnelle en direction du substrat et/ou un revêtement de blocage disposé sur la couche fonctionnelle à l'opposé du substrat.

Il est connu, par exemple de la demande de brevet européen N° EP 718 250 qu'une couche diélectrique dite « de mouillage » à base d'oxyde de zinc disposée directement sous une couche fonctionnelle métallique à base d'argent, en direction du substrat porteur, favorise l'obtention d'un état cristallographique adéquat de la couche fonctionnelle métallique tout en présentant l'avantage de pouvoir supporter un traitement thermique à haute température de bombage, trempe.

Ce document divulgue par ailleurs l'effet favorable de la présence d'une couche déposée sous forme métallique directement sur et au contact de la couche fonctionnelle à base d'argent pour la protection de la couche fonctionnelle pendant le dépôt des autres couches au-dessus et pendant un traitement thermique à haute température. L'homme du métier connaît ce type de couche sous l'appellation générique de « couche de blocage » ou « blocker ».

Ce document divulgue surtout que la présence d'une couche barrière, comprenant par exemple du nitrure de silicium, dans chacun des revêtements antireflet, l'une en dessous de la couche de mouillage en direction du substrat et l'autre au-dessus de la couche de blocage, permet de réaliser un empilement qui résiste bien à un traitement thermique de bombage ou de trempe.

La demande internationale de brevet N° WO 2010/103224 expose un substrat selon le préambule de la revendication 1.

Un but de l'invention est d'améliorer l'art antérieur, en mettant au point un nouveau type d'empilement de couches monocouche fonctionnelle qui présente une faible résistance par carré (et donc une émissivité réduite) mais aussi une transmission lumineuse élevée et un facteur solaire élevé, et cela éventuellement après un (ou des) traitement(s) thermique(s) à haute température de bombage et/ou trempe et/ou recuit.

Un but de l'invention est par ailleurs que l'empilement présente une colorimétrie favorable, et cela éventuellement après un (ou des) traitement(s) thermique(s) à haute température de bombage et/ou trempe et/ou recuit et notamment une couleur en réflexion côté empilement qui n'est pas trop rouge et/ou une couleur en transmission qui n'est pas trop jaune.

Il a été découvert que, d'une manière surprenante, la présence d'une couche comprenant du nitrure de silicium-zirconium avec une certaine proportion atomique de zirconium par l'ensemble formé par le silicium et le zirconium, dans un tel empilement avait des effets très favorables sur l'obtention d'un facteur solaire plus élevé et cela tant en configuration double vitrage qu'en configuration triple vitrage et sur l'obtention d'une telle colorimétrie.

L'invention a ainsi pour objet, dans son acception la plus large, un substrat transparent selon la revendication 1. Les revendications dépendantes présentent des variantes avantageuses.

Le substrat transparent est ainsi muni sur une face principale d'un empilement de couches minces comportant une seule couche fonctionnelle métallique à propriétés de réflexion dans l'infrarouge et/ou dans le rayonnement solaire, notamment à base d'argent ou d'alliage métallique contenant de l'argent, et deux revêtements antireflet, lesdits revêtements antireflet comportant chacun au moins une couche diélectrique, ladite couche fonctionnelle étant disposée entre les deux revêtements antireflet. Ce substrat est remarquable en ce qu'au moins le revêtement antireflet situé entre ledit substrat et ladite couche fonctionnelle, voire les deux revêtements antireflet comporte(nt) une couche comportant du nitrure de silicium zirconium, SiₓZr_{y}N_{z}, avec un ratio atomique de Zr sur la somme Si + Zr, y / (x + y), qui est compris entre 25,0 % et 40,0 % en intégrant ces valeurs.

Une plage de ratio atomique de Zr sur la somme Si + Zr, y / (x + y) particulièrement adéquate entre 26,32 % et 37,5 % en intégrant ces valeurs. Ce matériau peut être déposé avec une cible comportant de 70,0 % à 60,0 % atomique de Si pour 25,0 % à 36,0 % atomique de Zr ; cette cible étant pulvérisée dans une atmosphère contenant de l'azote.

Une autre plage de ratio atomique de Zr sur la somme Si + Zr, y / (x + y) particulièrement adéquate est entre 27,0 % et 37,0 % en intégrant ces valeurs.

Il est possible que ladite couche comportant du nitrure de silicium zirconium, SiₓZr_{y}N_{z}, voire que chaque couche comportant du nitrure de silicium zirconium SiₓZr_{y}N_{z}, comporte un ratio atomique de Zr sur la somme Si + Zr qui est compris entre 26,0 % et 30,0 % en intégrant ces valeurs, ou compris entre 31,0 % et 38,0 % en intégrant ces valeurs, ou compris entre 25,5 % et 32,5 % en intégrant ces valeurs.

Le revêtement antireflet situé entre ledit substrat et ladite couche fonctionnelle peut être le seul des deux revêtements antireflet à comporter une couche comportant du nitrure de silicium zirconium, SiₓZr_{y}N_{z}, et éventuellement il peut comporter une seule couche comportant du nitrure de silicium zirconium, SiₓZr_{y}N_{z}, avec un ratio atomique de Zr sur la somme Si + Zr, y / (x + y), qui est compris entre 25,0 % et 40,0 % en intégrant ces valeurs, voire entre 27,0 % et 37,0 % en intégrant ces valeurs.

Dans le cas où l'empilement comporte plusieurs couches comportant du nitrure de silicium zirconium, SiₓZr_{y}N_{z}, alors le ratio atomique de Zr sur la somme Si + Zr, y / (x + y) pour chacune de ces couches est, de préférence compris entre 25,0 % et 40,0 % en intégrant ces valeurs, voire pour chacune de ces couches est entre 27,0 % et 37,0 % en intégrant ces valeurs mais il n'est pas forcément le même pour toutes ces couches comportant du nitrure de silicium zirconium, SiₓZr_{y}N_{z}.

Il est possible que le rapport y / (x + y) soit différent pour deux couches comportant du nitrure de silicium zirconium, SiₓZr_{y}N_{z}, dudit empilement.

Dans le cas où chacun des deux revêtements antireflet comporte une couche comportant du nitrure de silicium zirconium, SiₓZr_{y}N_{z}, éventuellement ils peuvent comporter chacun une seule couche comportant du nitrure de silicium zirconium, SiₓZr_{y}N_{z}, avec un ratio atomique de Zr sur la somme Si + Zr, y / (x + y), qui est compris entre 25,0 % et 40,0 % en intégrant ces valeurs, voire entre 27,0 % et 37,0 % en intégrant ces valeurs, ou compris entre 26,0 % et 30,0 % en intégrant ces valeurs, ou compris entre 31,0 % et 38,0 % en intégrant ces valeurs, ou compris entre 25,5 % et 32,5 % en intégrant ces valeurs.

Une plage de ratio atomique de Zr sur la somme Al + Si + Zr, y / (w + x + y) particulièrement adéquate est entre 25,0 % et 36,0 % en intégrant ces valeurs. Ce matériau peut être déposé avec une cible comportant de 70,0 % à 60,0 % atomique de Si pour 25,0 % à 36,0 % atomique de Zr avec 5,0 % atomique de Al dans tous les cas ; cette cible étant pulvérisée dans une atmosphère contenant de l'azote.

Par « substrat transparent » au sens de la présente invention, il faut comprendre que le substrat n'est pas opaque et qu'il présenterait sans l'empilement une transmission lumineuse d'au moins 5 %.

Par « revêtement » au sens de la présente invention, il faut comprendre qu'il peut y avoir une seule couche ou plusieurs couches de matériaux différents à l'intérieur du revêtement.

Par « au contact » on entend au sens de l'invention qu'aucune couche n'est interposée entre les deux couches considérées.

Par « à base de » on entend au sens de l'invention que l'élément ou le matériau ainsi désigné est présent à plus de 50 % atomique dans la couche considérée.

Par ailleurs, dans le présent document, tous les indices de réfraction sont indiquées par rapport à une longueur d'onde de 550 nm ; les épaisseurs optiques des couches sont le produit de l'épaisseur physique de cette couche par cet indice de réfraction à cette longueur d'onde et les épaisseurs optiques des revêtement sont la somme des épaisseurs optiques de toutes les couches diélectriques du revêtement ; par défaut, si la distinction physique/optique n'est pas indiquée pour une épaisseur, c'est qu'il s'agit d'une épaisseur physique.

Dans le présent document, les couches diélectriques peuvent être différenciées en trois catégories :
- les couches bas indice dont l'indice de réfraction n < 1,95
- les couches d'indice moyen dont l'indice de réfraction 1,95 ≤ n < 2,10
- les couches haut indice dont l'indice de réfraction n > 2,10.

Avantageusement, l'unique couche fonctionnelle métallique à propriétés de réflexion dans l'infrarouge et/ou dans le rayonnement solaire, est une couche continue.

Avantageusement, l'empilement selon l'invention ne comporte pas de couche comprenant de l'oxyde de titane ; Le dioxyde de titane, TiO₂, présente un indice de réfraction très élevé et cet indice peut être trop élevé pour les applications visées. L'oxyde de titane sous-stoechiométrique, TiO_{b} avec b qui est un nombre inférieur à 2 peut constituer une couche haut indice mais son indice de réfraction est fonction de son oxydation et son oxydation est difficile à contrôler industriellement ; l'empilement selon l'invention est ainsi plus facile à fabriquer industriellement.

De préférence, ladite couche comportant du nitrure de silicium zirconium, SiₓZr_{y}N_{z}, de l'empilement selon l'invention, ou chacune des couches comportant du nitrure de silicium zirconium de l'empilement selon l'invention, ne comporte pas de titane.

De préférence, ladite couche comportant du nitrure de silicium zirconium, SiₓZr_{y}N_{z}, de l'empilement selon l'invention est en nitrure de silicium zirconium, SiₓZr_{y}N_{z} ou est en nitrure de silicium zirconium dopé à l'aluminium, SiₓZr_{y}N_{z}:Al.

De préférence, ladite couche comportant du nitrure de silicium zirconium, SiₓZr_{y}N_{z}, présente une nitruration z comprise entre 4/3 (x + y) et 5/3 (x + y) en intégrant ces valeurs ; de préférence encore, chaque couche comportant du nitrure de silicium zirconium, SiₓZr_{y}N_{z}, présente une nitruration z comprise entre 4/3 (x + y) et 5/3 (x + y) en intégrant ces valeurs.

De préférence par ailleurs, ladite couche comportant du nitrure de silicium zirconium dudit empilement, ou chacune des couches comportant du nitrure de silicium zirconium dudit empilement, ne comporte pas d'oxygène introduit volontairement. La présence d'oxygène dans la ou les couche comportant du nitrure de silicium zirconium, SiₓZr_{y}N_{z}, est à éviter car cela provoque une diminution de l'indice de réfraction de la couche. Par le fait que cette couche ne comporte pas d'oxygène, il faut comprendre qu'il n'y a pas d'oxygène en quantité significative par rapport à l'azote, c'est-à-dire en quantité relative d'au moins 5 % atomique rapporté à la quantité totale d'azote et d'oxygène, sachant que l'affinité des éléments Si et Zr est plus grande pour l'oxygène que pour l'azote.

Dans une variante particulière, le revêtement antireflet situé entre ledit substrat et ladite couche fonctionnelle comporte en outre une couche comportant du nitrure de silicium sans zirconium, ladite couche comportant du nitrure de silicium sans zirconium étant de préférence située entre ledit substrat et ladite couche comportant du nitrure de silicium zirconium, SiₓZr_{y}N_{z}, et de préférence encore à la fois directement sur ladite face principale du substrat et directement sous ladite couche comportant du nitrure de silicium zirconium, SiₓZr_{y}N_{z}.

De préférence alors, ladite couche du revêtement antireflet situé entre ledit substrat et ladite couche fonctionnelle et comportant du nitrure de silicium sans zirconium présente une épaisseur comprise entre 5,0 et 25,0 nm en incluant ces valeurs, voire entre 15,0 et 20,0 nm en incluant ces valeur.

Dans une autre variante particulière, éventuellement cumulable avec la précédente, le revêtement antireflet situé au-dessus de ladite couche fonctionnelle à l'opposé dudit substrat comporte en outre une couche comportant du nitrure de silicium sans zirconium, ladite couche comportant du nitrure de silicium sans zirconium étant de préférence située au-dessus de ladite couche comportant du nitrure de silicium zirconium, SiₓZr_{y}N_{z}.

De préférence alors, ladite couche du revêtement antireflet situé au-dessus de ladite couche fonctionnelle et comportant du nitrure de silicium sans zirconium présente une épaisseur comprise entre 25,0 et 35,0 nm en incluant ces valeurs.

Ces solutions permettent de diminuer le coût car le nitrure de silicium sans zirconium coûte moins cher que le nitrure de silicium-zirconium.

Dans une variante particulière, le revêtement antireflet situé au-dessus de ladite couche fonctionnelle et à l'opposé dudit substrat comporte en outre une couche en un matériau diélectrique à faible indice, notamment à base d'oxyde de silicium. Le matériau de cette couche être constitué uniquement de Si et de O ; il peut être en particulier du dioxyde de silicium ou du dioxyde de silicium dopé à l'aluminium. Cette couche en un matériau diélectrique à faible indice est, de préférence, la dernière couche diélectrique du revêtement antireflet situé au-dessus de ladite couche fonctionnelle.

Le matériau de cette couche diélectrique d'indice bas présente de préférence un indice compris entre 1,60 et 1,80 ; La couche présente de préférence une épaisseur comprise entre 15,0 et 60,0 nm, voire entre 20,0 et 58,0 nm, voire entre 30,0 et 55,0 nm.

Une couche à base d'oxyde de zinc peut être située en dessous et au contact de ladite couche fonctionnelle. Cela a pour effet de participer activement à l'obtention d'une couche fonctionnelle métallique présentant un taux de cristallisation élevée, et ainsi une résistance par carré faible, et donc une faible émissivité.

De préférence, ladite couche comportant du nitrure de silicium zirconium, SiₓZr_{y}N_{z}, qui est située entre ledit substrat et ladite couche fonctionnelle présente une épaisseur comprise entre 10,0 et 30,0 nm en incluant ces valeurs.

De préférence par ailleurs, ladite couche comportant du nitrure de silicium zirconium, SiₓZr_{y}N_{z}, qui est située au-dessus de ladite couche fonctionnelle à l'opposé dudit substrat présente une épaisseur comprise entre 6,0 et 12,0 nm en incluant ces valeurs.

De préférence, l'empilement ne comporte aucune couche comportant du nitrure de silicium zirconium, SiₓZr_{y}N_{z}, qui ne serait pas avec un ratio atomique de Zr sur la somme Si + Zr, y / (x + y), qui est compris entre 25,0 % et 40,0 %.

L'empilement peut ainsi comporter une dernière couche (« overcoat » en anglais), c'est-à-dire une couche de protection. Cette couche de protection présente, de préférence, une épaisseur physique comprise entre 0,5 et 10,0 nm.

Le vitrage selon l'invention incorpore au moins le substrat porteur de l'empilement selon l'invention, éventuellement associé à au moins un autre substrat. Chaque substrat peut être clair ou coloré. Un des substrats au moins notamment peut être en verre coloré dans la masse. Le choix du type de coloration va dépendre du niveau de transmission lumineuse et/ou de l'aspect colorimétrique recherchés pour le vitrage une fois sa fabrication achevée.

Le vitrage selon l'invention peut présenter une structure feuilletée, associant notamment au moins deux substrats rigides du type verre par au moins une feuille de polymère thermoplastique, afin de présenter une structure de type verre/empilement de couches minces/feuille(s)/verre. Le polymère peut notamment être à base de polyvinylbutyral PVB, éthylène vinylacétate EVA, polyéthylène téréphtalate PET, polychlorure de vinyle PVC.

Le vitrage peut par ailleurs présenter une structure de type verre/empilement de couches minces/feuille(s) de polymère.

Les vitrages selon l'invention sont aptes à subir un traitement thermique sans dommage pour l'empilement de couches minces. Ils sont donc éventuellement bombés et/ou trempés.

Le vitrage peut être bombé et/ou trempé en étant constitué d'un seul substrat, celui muni de l'empilement. Il s'agit alors d'un vitrage dit « monolithique ». Dans le cas où ils sont bombés, notamment en vue de constituer des vitrages pour véhicules, l'empilement de couches minces se trouve de préférence sur une face au moins partiellement non plane.

Le vitrage peut aussi être un vitrage multiple, notamment un double-vitrage, au moins le substrat porteur de l'empilement pouvant être bombé et/ou trempé. Il est préférable dans une configuration de vitrage multiple que l'empilement soit disposé de manière à être tourné du côté de la lame de gaz intercalaire. Dans une structure feuilletée, l'empilement peut être en contact avec la feuille de polymère.

Le vitrage peut aussi être un triple vitrage constitué de trois feuilles de verre séparées deux par deux par une lame de gaz. Dans une structure en triple vitrage, le substrat porteur de l'empilement peut être en face 2 et/ou en face 5, lorsque l'on considère que le sens incident de la lumière solaire traverse les faces dans l'ordre croissant de leur numéro.

Lorsque le vitrage est monolithique ou multiple du type double-vitrage, triple vitrage ou vitrage feuilleté, au moins le substrat porteur de l'empilement peut être en verre bombé ou trempé, ce substrat pouvant être bombé ou trempé avant ou après le dépôt de l'empilement.

La présente invention se rapporte par ailleurs à un procédé de fabrication du substrat selon l'invention, dans lequel ladite couche comportant du nitrure de silicium zirconium, SiₓZr_{y}N_{z} est fabriquée par pulvérisation, dans une atmosphère comportant de l'azote, d'une cible comportant un ratio atomique de Zr sur la somme Si + Zr, y / (x + y), qui est compris entre 25,0 % et 40,0 % en intégrant ces valeurs, voire 26,32 % et 37,5 % en intégrant ces valeurs, voire entre 27,0 % et 37,0 % en intégrant ces valeurs.

De préférence, ladite atmosphère ne comporte pas d'oxygène. Par le fait que cette atmosphère ne comporte pas d'oxygène, il faut comprendre qu'il n'y a pas d'oxygène introduit volontairement dans l'atmosphère de pulvérisation de ladite cible.

La présente invention se rapporte par ailleurs à une cible pour la mise en oeuvre du procédé selon l'invention, ladite cible comportant un ratio atomique de Zr sur la somme Si + Zr, y / (x + y), qui est compris entre 25,0 % et 40,0 % en intégrant ces valeurs, voire 26,32 % et 37,5 % en intégrant ces valeurs, voire entre 27,0 % et 37,0 % en intégrant ces valeurs.

Avantageusement, la présente invention permet ainsi de réaliser un empilement de couches minces monocouche fonctionnelle métallique qui présente un facteur solaire plus élevé et un aspect colorimétrique satisfaisant, notamment après traitement thermique de bombage ou trempe.

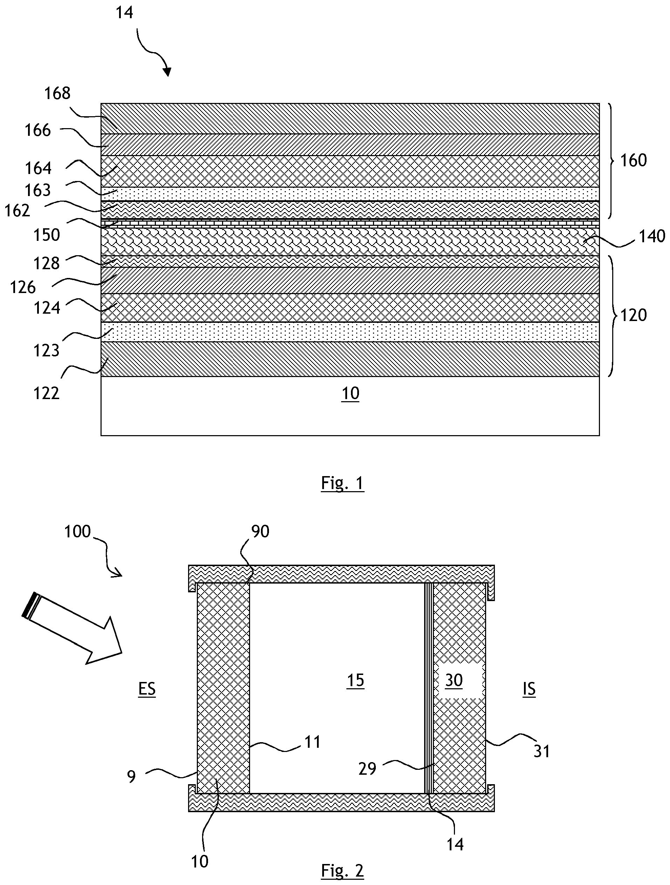

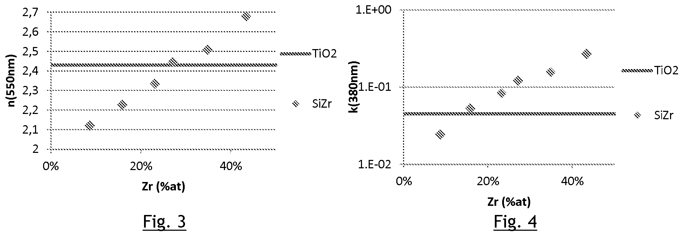

Les détails et caractéristiques avantageuses de l'invention ressortent des exemples non limitatifs suivants, illustrés à l'aide des figures ci-jointes illustrant :
- en figure 1, un empilement monocouche fonctionnelle, la couche fonctionnelle étant déposée directement sous un revêtement de sur-blocage ;
- en figure 2, une solution de double vitrage incorporant un empilement monocouche fonctionnelle ;
- en figure 3, la courbe de l'indice de réfraction, à 550 nm, du nitrure de silicium-zirconium (« SiZr ») en fonction de la teneur en Zr par rapport à la somme de Zr + Si, ainsi que l'indice de réfraction, à 550 nm, du dioxyde de titane TiO₂ ; et
- en figure 4, la courbe du coefficient d'absorption, à 380 nm, du nitrure de silicium-zirconium(« SiZr ») en fonction de la teneur en Zr par rapport à la somme de Zr + Si, ainsi que le coefficient d'absorption, à 380 nm, du dioxyde de titane TiO₂.

Dans les figures 1 et 2, les proportions entre les épaisseurs des différentes couches ou des différents éléments ne sont pas respectées afin de faciliter leur lecture.

La figure 1 illustre une structure d'un empilement 14 monocouche fonctionnelle selon l'invention déposé sur une face 29 d'un substrat 30 verrier, transparent, dans laquelle la couche fonctionnelle 140 unique, en particulier à base d'argent ou d'alliage métallique contenant de l'argent, est disposée entre deux revêtements antireflet, le revêtement antireflet sous-jacent 120 situé en dessous de la couche fonctionnelle 140 en direction du substrat 30 et le revêtement antireflet sus-jacent 160 disposé au-dessus de la couche fonctionnelle 140 à l'opposé du substrat 30.

Ces deux revêtements antireflet 120, 160, comportent chacun au moins une couche diélectrique 122, 123, 124, 126, 128 ; 162, 163, 164, 166, 168.

Eventuellement, d'une part la couche fonctionnelle 140 peut être déposée directement sur un revêtement de sous-blocage (non illustré) disposé entre le revêtement antireflet sous-jacent 120 et la couche fonctionnelle 140 et d'autre part la couche fonctionnelle 140 peut être déposée directement sous un revêtement de sur-blocage 150 disposé entre la couche fonctionnelle 140 et le revêtement antireflet sus-jacent 160.

Les couches de sous et/ou sur-blocage, bien que déposées sous forme métalliques et présentées comme étant des couches métalliques, sont parfois dans la pratique des couches oxydées car une de leurs fonctions (en particulier pour la couche de sur-blocage) est de s'oxyder au cours du dépôt de l'empilement afin de protéger la couche fonctionnelle.

Lorsqu'un empilement est utilisé dans un vitrage multiple 100 de structure double vitrage, comme illustré en figure 2, ce vitrage comporte deux substrats 10, 30 qui sont maintenus ensemble par une structure de châssis 90 et qui sont séparés l'un de l'autre par une lame de gaz intercalaire 15.

Le vitrage réalise ainsi une séparation entre un espace extérieur ES et un espace intérieur IS.

L'empilement peut être positionné en face 3 (sur la feuille la plus à l'intérieur du bâtiment en considérant le sens incident de la lumière solaire entrant dans le bâtiment et sur sa face tournée vers la lame de gaz).

La figure 2 illustre ce positionnement (le sens incident de la lumière solaire entrant dans le bâtiment étant illustré par la double flèche) en face 3 d'un empilement de couches minces 14 positionné sur une face intérieure 29 du substrat 30 en contact avec la lame de gaz intercalaire 15, l'autre face 31 du substrat 30 étant en contact avec l'espace intérieur IS.

Toutefois, il peut aussi être envisagé que dans cette structure de double vitrage, l'un des substrats présente une structure feuilletée.

Les couches déposées peuvent être classées en trois catégories :
i- les couches en matériau antireflet/diélectrique, présentant un rapport n/k sur toute la plage de longueur d'onde du visible supérieur en 5 : les couches à base de nitrure de silicium, à base de nitrure de silicium-zirconium, à base d'oxyde de zinc, à base d'oxyde de zinc et d'étain, à base d'oxyde de titane, à base d'oxyde titane-zirconium, à base d'oxyde de silicium, ... ;
ii- les couches fonctionnelles métalliques en matériau à propriétés de réflexion dans l'infrarouge et/ou dans le rayonnement solaire : par exemple à base d'argent ou en argent ; Il a été constaté que l'argent présente un rapport 0 < n/k < 5 sur toute la plage de longueur d'onde du visible, mais sa résistivité électrique à l'état massif est inférieure à 10⁻⁶ Ω.cm ;
iii- couches de sous-blocage et de sur-blocage destinées à protéger la couche fonctionnelle contre une modification de sa nature lors du dépôt de l'empilement et/ou lors d'un traitement thermique ; L'indice de réfraction de ces couches n'est pas considéré dans la définition optique de l'empilement.

Pour tous les exemples ci-après, les appellations de matériaux constitutifs de couche désignent les matériaux suivant, avec leur indice de réfraction mesuré à 550 nm :

**Tableau 2**

| Appellation | Matériau | Stoechiométrie | Indice |
|---|---|---|---|
| SiN | Nitrure de silicium dopé à l'aluminium | Si₃N₄:Al | 2,10 |
| ZnO | Oxyde de zinc | ZnO | 2,00 |
| NiCr | Alliage de Nickel-Chrome | Ni_{0,8}Cr_{0,2} | - |
| SiZrN' | Nitrure de silicium-zirconium habituel | Si_{x'}Zr_{y'}N_{z'} avec 5,0 % ≤ y' / (y' + x') < 25,0 % | 2,12 - 2,30 |
| SiZrN | Nitrure de silicium-zirconium enrichi en Zr | SiₓZr_{y}N_{z} avec 25,0 % ≤ y / (y + x) ≤ 40,0 % | 2,31 - 2,60 |
| SiZrN" | Nitrure de silicium-zirconium trop riche en Zr | Si_{x"}Zr_{y"}N_{z"} avec y" / (y" + x") > 40,0 % | > 2,60 |
| TiO | Oxyde de titane | TiO_{b} | 2,44 |
| TiZrO | Oxyde de titane-zirconium | Ti_{c}Zr_{d}O | 2,38 |
| SnZnO | Oxyde de zinc-étain | SnₑZn_{f}O | 1,95 |
| SiO | Dioxyde de silicium dopé à l'aluminium | SiO₂:Al | 1,55 |
| Ag | Ag | | - |

Ce tableau montre en particulier que le nitrure de silicium-zirconium enrichi en Zr, en sixième ligne, est un matériau dont l'indice de réfraction est plus élevé que celui du nitrure de silicium dopé à l'aluminium en seconde ligne et que plus élevé que celui du nitrure de silicium dopé au zirconium traditionnel en cinquième ligne.

L'indice de réfraction à 550 nm ainsi que le coefficient d'absorption à 380 nm, qui représente l'absorption du matériau dans le bleu, du nitrure de silicium-zirconium en fonction de la teneur atomique en Zr rapporté à la somme Zr + Si sont illustrés respectivement en figures 3 et 4. Il est considéré que le dopage à l'aluminium n'influe pas cet indice de réfraction et ce coefficient d'absorption.

Ces figures 3 et 4 montrent que nitrure de silicium-zirconium dont le rapport atomique de Zr / (Zr + Si) est compris entre 25,0 % et 40,0 % permet d'atteindre un haut indice de réfraction, tout en présentant une absorption dans le bleu qui est faible, afin d'éviter un aspect trop rouge en réflexion et trop jaune en transmission.

Dans cette plage de 25,0 à 40,0 %, l'indice de réfraction est proche de celui du TiO₂ ; Le nitrure de silicium-zirconium enrichi en Zr peut donc être substitué au TiO₂; Le coefficient d'absorption est certes plus élevé que celui du TiO₂ mais cette augmentation est relativement faible.

Dans la plage entre 27,0 % et 37,0 % %, l'indice de réfraction est quasi-identique à celui de celui du TiO₂ et le coefficient d'absorption est très proche de 0,1 qui est une valeur acceptable.

Le tableau 3 ci-après présente une configuration générale d'un empilement de couches minces, en lien avec la figure 1, avec pour les couches, les matériaux recommandés ainsi que les plages d'épaisseurs recommandées pour cette configuration générale.

**Tableau 3**

| N° couche | revêtement | matériau | épaisseurs (nm) |
|---|---|---|---|
| 168 | 160 | SiN | 25,0 - 35,0 |
| 166 | | SiZrN | 6,0 - 12,0 |
| 162 | | ZnO | 3,0 - 8,0 |
| 150 | | NiCr | 0 - 1,0 |
| 140 | | Ag | 9,0 - 16,0 |
| 128 | 120 | ZnO | 3,0 - 8,0 |
| 126 | | SiZrN | 10,0 - 30,0 |
| 124 | | SiZrN' | 0 - 15,0 |
| 122 | | SiN | 5,0 - 15,0 |

Dans cette configuration, les deux revêtements antireflets 120 et 160 comportent chacun une couche SiZrN à base de nitrure de silicium-zirconium enrichi en Zr.

Lorsque l'empilement comporte au moins une couche SiZrN à base de nitrure de silicium-zirconium enrichi en Zr dans chacun des deux revêtements antireflet, dans le revêtement antireflet sous-jacent 120 la couche à base de nitrure de silicium-zirconium enrichi en Zr, SiₓZr_{y}N_{z}, peut être l'unique couche haut indice ; son épaisseur optique peut représenter alors entre 70,0% (pour y / (x + y) proche de 25,0) % et 50,0% (pour y / (x + y) proche de 40,0 %) de l'épaisseur optique du revêtement antireflet sous-jacent 120.

Toutefois, il est possible que dans ce revêtement antireflet sous-jacent 120 comporte plusieurs couches à haut indice ; dans ce cas, dans le revêtement antireflet sous-jacent 120 la couche à base de nitrure de silicium-zirconium enrichi en Zr, SiₓZr_{y}N_{z}, peut peut représenter alors entre 35,0% (pour y / (x + y) proche de 25,0 %) et 25,5 % (pour y / (x + y) proche de 40,0 %) de l'épaisseur optique du revêtement antireflet sous-jacent 120 ; l'épaisseur optique de l'autre couche haut indice (comme par exemple une couche en SiZrN', à base de nitrure de silicium-zirconium traditionnelle) ou la somme de l'épaisseur optique des autres couches haut indice dans le cas où il y en a plusieurs, pouvant alors représenter respectivement entre 35,0% % et 25,0 % de l'épaisseur optique du revêtement antireflet sous-jacent 120.

Le tableau 4 ci-après présente une autre configuration générale d'un empilement de couches minces, en lien avec la figure 1, avec pour les couches, les matériaux recommandés ainsi que les plages d'épaisseurs recommandées pour cette configuration générale.

**Tableau 4**

| N° couche | revêtement | matériau | épaisseurs (nm) |
|---|---|---|---|
| 168 | 160 | SiN | 5,0 - 15,0 |
| 162 | | ZnO | 3,0 - 8,0 |
| 150 | | NiCr | 0 - 1,0 |
| 140 | | Ag | 9,0 - 16,0 |
| 128 | 120 | ZnO | 3,0 - 8,0 |
| 126 | | SiZrN | 10,0 - 30,0 |
| 124 | | SiZrN' | 0 - 15,0 |
| 122 | | SiN | 5,0 - 15,0 |

Dans cette configuration, seul le revêtement antireflet sous-jacent 120 comporte une couche 126 SiZrN à base de nitrure de silicium-zirconium enrichi en Zr ; le revêtement antireflet sus-jacent 160 ne comporte pas de couche à base de nitrure de silicium-zirconium enrichi en Zr.

Dans ce cas, la couche à base de nitrure de silicium-zirconium enrichi en Zr, SiₓZr_{y}N_{z}, peut être l'unique couche haut indice du revêtement antireflet sous-jacent 120 ; son épaisseur optique peut représenter alors entre 30,0% (pour y / (x + y) proche de 25,0) % et 60,0% (pour y / (x + y) proche de 40,0 %) de l'épaisseur optique du revêtement antireflet sous-jacent 120.

Toutefois, il est possible que le revêtement antireflet sous-jacent 120 comporte plusieurs couches à haut indice ; dans ce cas, l'épaisseur optique de la couche à base de nitrure de silicium-zirconium enrichi en Zr, SiₓZr_{y}N_{z}, peut représenter alors entre 15,0% (pour y / (x + y) proche de 25,0 %) et 30,0% (pour y / (x + y) proche de 40,0 %) de l'épaisseur optique du revêtement antireflet sous-jacent 120 ; l'épaisseur optique de l'autre couche haut indice (comme par exemple une couche en SiZrN', à base de nitrure de silicium-zirconium traditionnelle) ou la somme de l'épaisseur optique des autres couches haut indice dans le cas où il y en a plusieurs, pouvant alors représenter respectivement entre 15,0% et 30,0% de l'épaisseur optique du revêtement antireflet sous-jacent 120.

Pour tous les exemples ci-après, les conditions de dépôt des couches sont :

**Tableau 5**

| Couche | Cible employée | Pression de dépôt | Gaz |
|---|---|---|---|
| SiN | Si:Al à 92:8 % wt | 1,5.10⁻³ mbar | Ar/(Ar + N₂) à 55% |
| ZnO | Zn:O à 50:50 % atomique | 2.10⁻³ mbar | Ar/(Ar + O₂) à 90% |
| NiCr | Ni:Cr à 80:20 % atomique | 8.10⁻³ mbar | Ar à 100 % |
| SiZrN' | Si:Zr:Al à 78:17:5 % atomique | 2.10⁻³ mbar | Ar/(Ar + N₂) à 45 % |
| SiZrN | Si:Zr:Al à 68:27:5 % atomique ou à 58:37:5 % atomique | 2.10⁻³ mbar | Ar/(Ar + N₂) à 45 % |
| SiZrN" | Si:Zr:Al à 48:47:5 % atomique | 2.10⁻³ mbar | Ar/(Ar + N₂) à 45 % |
| TiO | TiO₂ | 2.10⁻³ mbar | Ar/(Ar + O₂) à 95 % |
| TiZrO | TiZrO₄ | 2.10⁻³ mbar | Ar/(Ar + O₂) à 95 % |
| SnZnO | Zn:Sn à 64:36 % atomique | 2.10⁻³ mbar | Ar/(Ar + O₂) à 50 % |
| SiO₂ | Si:Al à 92:8 % wt | 2.10⁻³ mbar | Ar/(Ar + O₂) à 50 % |
| Ag | Ag | 8.10⁻³ mbar | Ar à 100 % |

Dans tous les exemples ci-après l'empilement de couches minces est déposé sur un substrat en verre sodo-calcique clair d'une épaisseur de 4 mm de la marque Planiclear, distribué par la société SAINT-GOBAIN.

Les tableaux 6, 8, 10 et 11 ci-après exposent les épaisseurs physiques en nanomètres de chacune des couches ou des revêtements des exemples et le tableau 3 synthétisent les principales données relatives aux exemples 1 à 10.

Dans les tableaux 6, 8, 10 et 11, la colonne « N° » indique le numéro de la couche et la seconde colonne indique le revêtement, en lien avec la configuration de la figure 1 ; la troisième colonne indique le matériau déposé pour la couche de la première colonne, avec, pour les couches en « SiZrN », « SiZrN' » et « SiZrN" » une valeur entre parenthèses qui désigne, pour cette couche de cet exemple, le rapport atomique Zr / (Zr + Si + Al), en pourcentage.

Dans les tableaux 7, 9 et 12, les caractéristiques du substrat revêtu de l'empilement qui sont présentées consistent pour chacun de ces exemples, après un traitement thermique de trempe du substrat revêtu, à 650 °C pendant 10 minutes puis un refroidissement, en utilisant l'illuminant D65 2° pour les exemples 1 à 5 et l'illuminant D65 10° pour les exemples 6 à 18, en la mesure :
- pour TL, de la transmission lumineuse dans le visible, en %,
- pour Ta* et Tb*, des couleurs en transmission dans le système La*b*,
- pour RLc, de la réflexion lumineuse dans le visible, en %, côté empilement,
- pour Rca* et Rcb*, des couleurs en réflexion dans le système La*b*, côté empilement,
- pour RLg, de la réflexion lumineuse dans le visible, en %, côté verre,
- pour Rga* et Rgb*, des couleurs en réflexion dans le système La*b*, côté verre, et
- pour E, de l'émissivité.

Pour les exemples 1 à 5, « g » indique la mesure du facteur solaire dans une configuration de double vitrage, constitué d'un substrat extérieur en verre clair de 4 mm, d'un espace intercalaire de 16 mm rempli d'argon et d'un substrat intérieur en verre clair de 4 mm, avec l'empilement situé en face 3, c'est-à-dire sur la face du substrat intérieur tournée vers l'espace intercalaire.

Pour les exemples 6 à 18, « g » indique la mesure du facteur solaire dans une configuration de triple vitrage, constitué d'un substrat extérieur en verre clair de 4 mm, d'un espace intercalaire de 12 mm rempli d'argon, d'un substrat central en verre clair de 4 mm, d'un espace intercalaire de 12 mm rempli d'argon, et d'un substrat intérieur en verre clair de 4 mm, avec l'empilement situé en face 2 et 5, c'est-à-dire sur la face du substrat extérieur et du substrat intérieur qui est tournée vers l'espace intercalaire.

**Tableau 6**

| Ex. | | | **1** | **2** | **3** | **4** | **5** |
|---|---|---|---|---|---|---|---|
| N° | | | | | | | |
| 168 | 160 | SiN | 42,0 | 28,7 | 30,3 | 32,3 | 36,0 |
| **166** | | **SiZrN** | - | - | 9,0 (27 %) | 6,7 (37 %) | - |
| 164 | | SiZrN' ou SiZrN" | - | 11,8 (17 %) | - | - | 3,8 (47 %) |
| 162 | | ZnO | 5,0 | 5,0 | 5,0 | 5,0 | 5,0 |
| 150 | | NiCr | 1,0 | 1,0 | 1,0 | 1,0 | 1,0 |
| 140 | | Ag | 15,0 | 15,0 | 15,0 | 15,0 | 15,0 |
| 128 | 120 | ZnO | 5,0 | 5,0 | 5,0 | 5,0 | 5,0 |
| 126 | | **SiZrN** | - | - | 17,5 (27 %) | 13,7 (37 %) | - |
| 124 | | SiZrN' ou SiZrN" | - | 20,8 (17 %) | - | - | 8,7 (47 %) |
| 122 | | SiN | 28,6 | 5,0 | 5,0 | 9,0 | 15,3 |

**Tableau 7**

| Ex. | **1** | **2** | **3** | **4** | **5** |
|---|---|---|---|---|---|
| TL | 78,3 | 80,9 | 72,4 | 82,8 | 81,9 |
| Ta* | -1,3 | -1,2 | -1,3 | -1,5 | -1,5 |
| Tb* | 5,1 | 4,6 | 4,9 | 5,2 | 5,7 |
| RLc | 13,3 | 10,6 | 8,4 | 7,8 | 8,3 |
| Rca* | 2,9 | 2,6 | 2,4 | 2,2 | 2,3 |
| Rcb* | -14,8 | -14,2 | -12,1 | -10,2 | -9,5 |
| RLg | 16,2 | 13,3 | 11,1 | 10,5 | 11,2 |
| Rga* | 1,4 | 0,7 | -0,5 | -0,9 | -1,0 |
| Rgb* | -12,5 | -11,2 | -8,0 | -6,2 | -5,8 |
| E (%) | 2,2 | 2,2 | 2,2 | 2,2 | 2,2 |
| g (%) | 55,4 | 57,1 | 58,5 | 58,8 | 58,8 |

Dans la première série d'exemples, celle des tableaux 6 et 7, l'exemple 1 constitue un exemple de base de la technologie des empilements bas-émissif monocouche argent à couches barrières telle que divulguée dans la demande de brevet EP 718 250 : la couche fonctionnelle 140 en argent est déposée directement sur une couche 128 de mouillage en oxyde de zinc et une couche 150 de surbloqueur en NiCr est prévue juste sur cette couche fonctionnelle 140, puis une autre couche 162 en oxyde de zinc. Cet ensemble est encadré par une couche 122 barrière inférieure, à base de nitrure de silicium et une couche 168 barrière supérieure, également à base de nitrure de silicium.

Cet exemple 1 présente une transmission lumineuse TL élevée, de l'ordre de 78 % et une émissivité E faible, de l'ordre de 2 % ; son facteur solaire, g, en double vitrage est moyen, de l'ordre de 55 % et certaines données colorimétriques sont satisfaisantes dans le sens où, en particulier, Tb* est proche de 5,0, ce qui implique une couleur en transmission qui n'est pas trop jaune ; par contre, une donnée colorimétrique n'est pas satisfaisante : Rca* est trop élevé, ce implique une couleur en réflexion côté empilement qui est trop rouge.

L'exemple 2 constitue une amélioration de la technologie de base de l'exemple 1 car la transmission lumineuse TL est augmentée, ce qui engendre une augmentation du facteur solaire dans la même configuration de double vitrage. Bien sûr, l'émissivité est conservée puisque la couche fonctionnelle présente la même épaisseur et est encadrée directement par les mêmes couches. Tb* est proche de 5,0, ce qui est satisfaisant et Rca* est proche de 2,5, ce qui est également satisfaisant.

Ceci est obtenu par le fait que d'une part une partie de la couche 122 barrière inférieure est remplacée par une couche 124 haut indice et barrière et d'autre part une partie de la couche 168 barrière supérieure est remplacée par une couche 164 haut indice et barrière.

Cet exemple 2 est susceptible d'amélioration dans le sens où si la transmission lumineuse pouvait être très élevée, de l'ordre de 82 % ou plus, alors le facteur solaire pourrait être encore plus élevé.

L'exemple 3 constitue une amélioration du fait que la très haute transmission lumineuse permet d'atteindre un facteur solaire élevé, supérieur à 58 %. L'émissivité est bien sûr conservée et les données colorimétriques sont satisfaites car Tb* est proche de 5,0 et Rca* est proche de 2,5.

L'exemple 4 constitue aussi une amélioration du fait que la très haute transmission lumineuse, encore plus élevée que celle de l'exemple 3, permet d'atteindre un facteur solaire proche de 59 %. L'émissivité est bien sûr conservée et les données colorimétriques sont satisfaites car Tb* est proche de 5,0 et Rca* est proche de 2,5.

L'exemple 5 ne constitue pas une amélioration par rapport à l'exemple 4 car il présente une transmission lumineuse moins élevé et un facteur solaire moins élevée.

L'exemple 5 ne constitue pas une amélioration par rapport à l'exemple 2 car même s'il présente une très haute transmission lumineuse et permet d'atteindre un facteur solaire élevé, Tb* est trop éloigné de 5,0.

Dans une seconde série d'exemples, l'exemple de référence, N° 6, est choisi similaire à l'exemple 1 de la première série, avec la même succession de couche, mais avec une couche fonctionnelle moins épaisse que pour la première série.

**Tableau 8**

| Ex. | | | **6** | **7** | **8** | **9** | **10** |
|---|---|---|---|---|---|---|---|
| N° | | | | | | | |
| 168 | 160 | Si₃N₄ | 35,0 | 37,0 | 38,8 | 38,8 | 38,0 |
| 162 | | ZnO | 5,0 | 5,0 | 5,0 | 5,0 | 5,0 |
| 150 | | NiCr | 1,0 | 1,0 | 1,0 | 1,0 | 1,0 |
| 140 | | Ag | 9,8 | 9,8 | 9,8 | 9,8 | 9,8 |
| 128 | 120 | ZnO | 5,0 | 5,0 | 5,0 | 5,0 | 5,0 |
| 126 | | **SiZrN** | - | - | 19,4 (27 %) | 13,6 (37 %) | - |
| 124 | | SiZrN' ou SiZrN" | - | 29,2 (17 %) | - | - | 8,7 (47 %) |
| 122 | | Si₃N₄ | 34,4 | 5,4 | 16,0 | 24,4 | 31,1 |

**Tableau 9**

| Ex. | **6** | **7** | **8** | **9** | **10** |
|---|---|---|---|---|---|
| TL | 88,6 | 89,2 | 88,9 | 88,9 | 88,7 |
| Ta* | -0,9 | -1,0 | -1,1 | -1,3 | -1,2 |
| Tb* | 2,0 | 1,6 | 2,2 | 2,5 | 2,8 |
| RLc | 4,7 | 4,5 | 4,6 | 4,6 | 4,5 |
| Rca* | 2,6 | 2,1 | 2,0 | 1,9 | 1,9 |
| Rcb* | -12,0 | 7,8 | -6,5 | -6,2 | -6,0 |
| RLg | 5,9 | 5,3 | 5,5 | 5,4 | 5,4 |
| Rga* | 1,7 | 0,9 | -0,5 | -0,5 | -0,3 |
| Rgb* | -12,9 | -8,2 | -5,0 | -5,1 | -6,1 |
| E (%) | 4,2 | 4,2 | 4,2 | 4,2 | 4,2 |
| g (%) | 55,8 | 57,1 | 57,5 | 57,4 | 57,2 |

Dans la seconde série d'exemples, celle des tableaux 8 et 9, l'exemple 6 présente une transmission lumineuse TL élevée, et une émissivité E faible ; le facteur solaire, g, en triple vitrage avec deux empilements selon l'exemple, l'un en face 2 et l'autre en face 5, est moyen, de l'ordre de 55 % et certaines données colorimétriques sont satisfaisantes dans le sens où, en particulier, Tb* est proche de 2,0, ce qui implique une couleur en transmission qui n'est pas trop jaune ; par contre, une donnée colorimétrique n'est pas satisfaisante : Rca* est trop élevé, ce implique une couleur en réflexion côté empilement qui est trop rouge.

L'exemple 7 constitue une amélioration de la technologie de l'exemple 6 car la transmission lumineuse TL est augmentée, ce qui engendre une augmentation du facteur solaire dans la même configuration de triple vitrage. Bien sûr, l'émissivité est conservée puisque la couche fonctionnelle présente la même épaisseur et est encadrée directement par les mêmes couches. Tb* diminue, ce qui est satisfaisant, et Rca* est proche de 2,0, ce qui est également satisfaisant.

Ceci est obtenu par le fait qu'une partie de la couche 122 barrière inférieure est remplacée par une couche 124 haut indice et barrière.

Cet exemple 7 est susceptible d'amélioration dans le sens où le facteur solaire pourrait être encore plus élevé.

L'exemple 8 constitue une amélioration du fait que la transmission lumineuse est plus élevée que celle de l'exemple 6 ; elle n'est pas aussi élevée que celle de l'exemple 7 mais permet d'atteindre un facteur solaire supérieur à celui de l'exemple 7. L'émissivité est bien sûr conservée et les données colorimétriques sont satisfaites car Tb* est proche de 2,0 et Rca* est proche de 2,0.

L'exemple 9 constitue aussi une amélioration par rapport aux exemples 6 et 7 du fait que la transmission lumineuse est aussi élevée que celle de l'exemple 8 et que le facteur solaire est aussi élevé que celui de l'exemple 8. L'émissivité est bien sûr conservée et les données colorimétriques sont satisfaites car Tb* est proche de 2,0, même si elle s'en éloigne par rapport à l'exemple 8 et Rca* est proche de 2,0.

L'exemple 10 ne constitue pas une amélioration par rapport à l'exemple 9 car il présente une transmission lumineuse moins élevé et un facteur solaire moins élevée.

L'exemple 10 ne constitue pas une amélioration par rapport à l'exemple 7 car même s'il présente une transmission lumineuse élevée, Tb* est trop éloigné de la valeur de 2,0 obtenue avec l'exemple 6.

**Tableau 10**

| Ex. | | | **3** | **11** | **12** | **13** | **14** |
|---|---|---|---|---|---|---|---|
| N° | | | | | | | |
| 168 | 160 | SiN | 30,3 | 30,3 | 30,0 | 30,0 | 18,0 |
| 166 | | **SiZrN** | 9,0 (27 %) | - | - | - | - |
| 164 | | SiZrN" | - | 9,0 (47 %) | - | - | - |
| | | TiOₓ | - | - | 9,0 | - | - |
| | | TiZrOₓ | - | - | - | 9,0 | - |
| 163 | | SnZnO | - | - | - | - | 22,0 |
| 162 | | ZnO | 5,0 | 5,0 | 5,0 | 5,0 | 5,0 |
| 150 | | NiCr | 1,0 | 1,0 | 1,0 | 1,0 | - |
| 140 | | Ag | 15,0 | 15,0 | 15,0 | 15,0 | 15,0 |
| 128 | 120 | ZnO | 5,0 | 5,0 | 5,0 | 5,0 | 5,0 |
| 126 | | **SiZrN** | 17,5 (27 %) | - | - | - | - |
| 124 | | TiOₓ | - | 18,0 | 18,0 | - | - |
| | | TiZrOₓ | - | - | - | 18,0 | 19,0 |
| 123 | | SnZnO | - | - | - | - | 10,0 |
| 122 | | SiN | 5,0 | 15,3 | 15,3 | 15,3 | - |

Dans la troisième série d'exemples, celle du tableau 10, l'exemple 3 précédant est pris pour référence et les exemples 11 à 14 ont été conçus pour obtenir les mêmes propriétés optiques après traitement thermique que cet exemple 3 ; c'est la raison pour laquelle ces données ne sont pas indiquées.

L'exemple 14 est un exemple basé sur l'enseignement de la demande internationale de brevet N° WO 2014/191472.

Les exemples 11 à 14 ne résistent pas au traitement thermique de 650 °C pendant 10 minutes : l'exemple 11 présente de nombreux gros défauts, avec des taches en étoiles d'une largeur de l'ordre de 0,5 micron ; L'exemple 12 présente un voile très important et de très nombreux défauts fins, de l'ordre de 0,1 micron ; Les exemples 13 et 14 ne présentent pas de voile mais de très nombreux défauts fins, de l'ordre de 0,1 micron ; Seul l'exemple 3 est exempt de gros défaut, de défaut fin et de voile.

**Tableau 11**

| Ex. | | | **7** | **15** | **16** | **17** | **18** |
|---|---|---|---|---|---|---|---|
| N° | | | | | | | |
| 169 | 160 | SiO | - | 30,0 | 30,0 | 30,0 | 30,0 |
| 168 | | Si₃N₄ | 37,0 | 26,4 | 27,1 | 13,1 | 13,0 |
| 166 | | SiZrN | - | - | - | - | 13,0 (27 %) |
| 164 | | SiZrN' | - | - | - | 13,0 (17 %) | - |
| 162 | | ZnO | 5,0 | 5,0 | 5,0 | 5,0 | 5,0 |
| 150 | | NiCr | 1,0 | 1,0 | 1,0 | 1,0 | 1,0 |
| 140 | | Ag | 9,8 | 9,8 | 9,8 | 9,8 | 9,8 |
| 128 | 120 | ZnO | 5,0 | 5,0 | 5,0 | 5,0 | 5,0 |
| 126 | | **SiZrN** | - | - | 19,1 (27 %) | - | 21,1 (27 %) |
| 124 | | SiZrN' | 29,2 (17%) | 19,6 (17 %) | - | 21,5 (17 %) | - |
| 122 | | Si₃N₄ | 5,4 | 15,5 | 14,0 | 16,4 | 15,0 |

**Tableau 12**

| Ex. | **7** | **15** | **16** | **17** | **18** |
|---|---|---|---|---|---|
| TL | 89,2 | 88,8 | 89,2 | 89,0 | 89,3 |
| Ta* | -1,0 | -1,2 | -1,4 | -1,4 | -1,8 |
| Tb* | 1,6 | 1,7 | 1,9 | 2,4 | 2,7 |
| RLc | 4,5 | 4,6 | 4,4 | 4,7 | 4,7 |
| Rca* | 2,1 | 2,1 | 2,0 | 2,0 | 2,0 |
| Rcb* | 7,8 | -8,3 | -7,1 | -9,4 | -6,8 |
| RLg | 5,3 | 5,9 | 5,5 | 5,9 | 5,7 |
| Rga* | 0,9 | 0,7 | 0,4 | 1,2 | 1,0 |
| Rgb* | -8,2 | -6,5 | -4,4 | -8,7 | -6,6 |
| E (%) | 4,2 | 4,2 | 4,2 | 4,2 | 4,2 |
| g (%) | 57,1 | 57,4 | 58,1 | 57,9 | 58,7 |

Dans la quatrième série d'exemples, celle des tableaux 11 et 12, l'exemple 7 précédant est pris pour référence. Les exemples 15 et 17 correspondent chacun à une amélioration de cet exemple 7 avec l'insertion dans le revêtement diélectrique sus-jacent à la couche fonctionnelle 140, d'une couche en matériau diélectrique d'indice bas, la couche 169, en SiO. En outre, pour l'exemple 17, le revêtement diélectrique sus-jacent à la couche fonctionnelle 140, comporte une couche en matériau diélectrique d'indice haut, la couche 164, en SiZrN', c'est-à-dire en nitrure de silicium-zirconium traditionnel.

La couche 169 participe à l'obtention d'un facteur solaire plus élevé : comme visible dans le tableau 12, l'exemple 15 présente un facteur solaire, g, augmenté de 0,3 % en configuration triple vitrage comme expliqué auparavant, par rapport à celui de l'exemple 7 et l'exemple 17 présente un facteur solaire, g, augmenté de 0,8 % en configuration triple vitrage comme expliqué auparavant, par rapport à celui de l'exemple 7.

L'exemple 16 constitue un exemple selon l'invention et une amélioration de l'exemple 15 : le remplacement de la couche en matériau diélectrique d'indice haut, la couche 124, en SiZrN', par une couche matériau diélectrique d'indice plus haut, la couche 126, en SiZrN, c'est-à-dire en nitrure de silicium-zirconium enrichi en Zr permet d'augmenter encore le facteur solaire, de 0,7 % par rapport à celui de l'exemple 15, dans la même configuration de triple vitrage, grâce à l'obtention d'une transmission lumineuse très élevée, qui se trouve être celle de l'exemple 7.

L'exemple 18 constitue un exemple selon l'invention et une amélioration de l'exemple 17 : le remplacement de la couche matériau diélectrique d'indice haut, la couche 164, en SiZrN', par une couche matériau diélectrique d'indice plus haut, la couche 166, en SiZrN, c'est-à-dire en nitrure de silicium-zirconium enrichi en Zr permet d'augmenter encore le facteur solaire, de 0,8 % par rapport à celui de l'exemple 17, dans la même configuration de triple vitrage, grâce à l'obtention d'une transmission lumineuse très élevée.

Les exemples 15 à 18 ont été configurés avec une couche diélectrique d'indice bas, la couche 169, qui présente une épaisseur de 30 nm ; cette épaisseur constitue un choix favorable entre l'effet recherché d'amélioration du facteur solaire et la facilité de dépôt de cette couche. D'autres solutions sont acceptables avec une épaisseur de cette couche diélectrique d'indice bas comprise entre 15,0 et 60,0 nm. Le choix d'une épaisseur de cette couche diélectrique d'indice bas de 55,0 nm conduit par exemple à augmenter encore le facteur solaire de 0,3 %.

Les tableaux 7, 9 et 12 montrent par ailleurs que les exemples présentent des caractéristiques optiques acceptables au regard des attentes et notamment une faible coloration tant en transmission qu'en réflexion côté empilement ou côté verre, ainsi qu'une faible réflexion lumineuse dans le visible, tant côté empilement RLc que côté verre RLg.

Des essais ont par ailleurs été menés avec des cibles de 68,0 % à 66,0 % atomique de Si pour 27,0 % à 29,0 % atomique de Zr avec 5 % atomique de Al dans tous les cas, ce qui correspond à une plage de ratio atomique de Zr sur la somme Al + Si + Zr, y / (w + x + y) entre 27,0 % et 29,0 % en intégrant ces valeurs ; ces cibles étant pulvérisées dans une atmosphère contenant de l'azote.

Ces essais ont permis d'obtenir des couches d'indices de réfractions à 550 nm entre 2,37 et 2,42 en intégrant ces valeurs, ce qui est particulièrement favorable.

Du fait de la faible résistance par carré obtenue ainsi que des bonnes propriétés optiques (en particulier la transmission lumineuse dans le visible), il est possible, par ailleurs d'utiliser le substrat revêtu de l'empilement selon l'invention pour réaliser un substrat électrode transparent.

D'une manière générale, le substrat électrode transparent peut convenir pour un vitrage chauffant, pour un vitrage électrochrome, pour un écran de visualisation, ou encore pour une cellule (ou panneau) photovoltaïque et notamment pour une face arrière de cellule photovoltaïque transparente.

La présente invention est décrite dans ce qui précède à titre d'exemple. Il est entendu que l'homme du métier est à même de réaliser différentes variantes de l'invention sans pour autant sortir du cadre du brevet tel que défini par les revendications.

## Revendications

1. Substrat (30) transparent muni sur une face principale d'un empilement de couches minces comportant une seule couche fonctionnelle (140) métallique à propriétés de réflexion dans l'infrarouge et/ou dans le rayonnement solaire, notamment à base d'argent ou d'alliage métallique contenant de l'argent, et deux revêtements antireflet (120, 160), lesdits revêtements antireflet comportant chacun au moins une couche diélectrique (122, 128 ; 162, 168), ladite couche fonctionnelle (140) étant disposée entre les deux revêtements antireflet (120, 160), ***caractérisé en ce qu***'au moins le revêtement antireflet (120) situé entre ledit substrat (30) et ladite couche fonctionnelle (140), voire les deux revêtements antireflet (120, 160) comporte(nt) une couche (126, 166) comportant du nitrure de silicium zirconium, SiₓZr_{y}N_{z}, avec un ratio atomique de Zr sur la somme Si + Zr, y / (x + y), qui est compris entre 25,0 % et 40,0 % en intégrant ces valeurs, voire 26,32 % et 37,5 % en intégrant ces valeurs, voire entre 27,0 % et 37,0 % en intégrant ces valeurs.

2. Substrat (30) selon la revendication 1, ***caractérisé en ce que*** ladite couche (126, 166) comportant du nitrure de silicium zirconium, SiₓZr_{y}N_{z}, présente une nitruration z comprise entre 4/3 (x + y) et 5/3 (x + y) en intégrant ces valeurs.

3. Substrat (30) selon la revendication 1 ou 2, ***caractérisé en ce que*** ladite couche (126, 166) comportant du nitrure de silicium zirconium, SiₓZr_{y}N_{z}, ne comporte pas d'oxygène.

4. Substrat (30) selon l'une quelconque des revendications 1 à 3, ***caractérisé en ce que*** le revêtement antireflet (120) situé entre ledit substrat (30) et ladite couche fonctionnelle (140) comporte en outre une couche (122) comportant du nitrure de silicium sans zirconium, ladite couche (122) comportant du nitrure de silicium sans zirconium étant de préférence située entre ledit substrat (30) et ladite couche (126) comportant du nitrure de silicium zirconium, SiₓZr_{y}N_{z}.

5. Substrat (30) selon la revendication 4, ***caractérisé en ce que*** ladite couche (122) comportant du nitrure de silicium sans zirconium présente une épaisseur comprise entre 5,0 et 25,0 nm en incluant ces valeurs, voire entre 15,0 et 20,0 nm en incluant ces valeurs.

6. Substrat (30) selon l'une quelconque des revendications 1 à 5, ***caractérisé en ce que*** le revêtement antireflet (160) situé au-dessus de ladite couche fonctionnelle (140) à l'opposé dudit substrat (30) comporte en outre une couche (168) comportant du nitrure de silicium sans zirconium, ladite couche (168) comportant du nitrure de silicium sans zirconium étant de préférence située au-dessus de ladite couche (166) comportant du nitrure de silicium zirconium, SiₓZr_{y}N_{z}.

7. Substrat (30) selon la revendication 6, ***caractérisé en ce que*** ladite couche (168) comportant du nitrure de silicium sans zirconium présente une épaisseur comprise entre 25,0 et 35,0 nm en incluant ces valeurs.

8. Substrat (30) selon l'une quelconque des revendications 1 à 7, ***caractérisé en ce que*** le revêtement antireflet (160) situé au-dessus de ladite couche fonctionnelle (140) et à l'opposé dudit substrat (30) comporte en outre une couche (169) en un matériau diélectrique à faible indice, notamment à base d'oxyde de silicium.

9. Substrat (30) selon l'une quelconque des revendications 1 à 8, ***caractérisé en ce qu***'une couche à base d'oxyde de zinc est située en dessous et au contact de ladite couche fonctionnelle (140).

10. Substrat (30) selon l'une quelconque des revendications 1 à 9, ***caractérisé en ce que*** ladite couche (126) comportant du nitrure de silicium zirconium, SiₓZr_{y}N_{z}, qui est située entre ledit substrat (30) et ladite couche fonctionnelle (140) présente une épaisseur comprise entre 10,0 et 30,0 nm en incluant ces valeurs.

11. Substrat (30) selon l'une quelconque des revendications 1 à 10, ***caractérisé en ce que*** ladite couche (166) comportant du nitrure de silicium zirconium, SiₓZr_{y}N_{z}, qui est située au-dessus de ladite couche fonctionnelle (140) à l'opposé dudit substrat (30) présente une épaisseur comprise entre 6,0 et 12,0 nm en incluant ces valeurs.

12. Vitrage (100) incorporant au moins un substrat (30) selon l'une quelconque des revendications 1 à 11, éventuellement associé à au moins un autre substrat.

13. Vitrage (100) selon la revendication 12 monté en monolithique ou en vitrage multiple du type double-vitrage ou triple vitrage ou vitrage feuilleté, ***caractérisé en ce qu'au*** moins le substrat porteur de l'empilement est bombé et/ou trempé.

14. Utilisation du substrat selon l'une quelconque des revendications 1 à 11, pour réaliser une électrode transparente d'un vitrage chauffant ou d'un vitrage électrochrome ou d'un dispositif d'éclairage ou d'un dispositif de visualisation ou d'un panneau photovoltaïque.

15. Procédé de fabrication du substrat selon l'une quelconque des revendications 1 à 11, dans lequel ladite couche (126, 166) comportant du nitrure de silicium zirconium, SiₓZr_{y}N_{z} est fabriquée par pulvérisation, dans une atmosphère comportant de l'azote, d'une cible comportant un ratio atomique de Zr sur la somme Si + Zr, y / (x + y), qui est compris entre 25,0 % et 40,0 % en intégrant ces valeurs, voire 26,32 % et 37,5 % en intégrant ces valeurs, voire entre 27,0 % et 37,0 % en intégrant ces valeurs.

16. Procédé selon la revendication 15, **caractérisé en ce que** ladite atmosphère ne comporte pas d'oxygène.

17. Cible pour la mise en oeuvre du procédé selon la revendication 15 ou la revendication 16 comportant un ratio atomique de Zr sur la somme Si + Zr, y / (x + y), qui est compris entre 25,0 % et 40,0 % en intégrant ces valeurs, voire 26,32 % et 37,5 % en intégrant ces valeurs, voire entre 27,0 % et 37,0 % en intégrant ces valeurs.

## Patentansprüche

1. Transparentes Substrat (30), das auf einer Hauptfläche mit einem Stapel dünner Schichten versehen ist, umfassend eine einzige metallische Funktionsschicht (140) mit Reflexionseigenschaften im Infrarotbereich und/oder in der Sonnenstrahlung, insbesondere auf Basis von Silber oder einer silberhaltigen Metalllegierung, und zwei Antireflexbeschichtungen (120, 160), wobei die Antireflexbeschichtungen jeweils mindestens eine dielektrische Schicht (122, 128; 162, 168) umfassen, wobei die Funktionsschicht (140) zwischen den zwei Antireflexbeschichtungen (120, 160) angeordnet ist, ***dadurch gekennzeichnet, dass*** mindestens die Antireflexbeschichtung (120), die zwischen dem Substrat (30) und der Funktionsschicht (140) angeordnet ist, sogar die zwei Antireflexbeschichtungen (120, 160), eine Schicht (126, 166), umfassend Silicium-Zirkonium-Nitrid, SiₓZr_{y}N_{z}, mit einem Atomverhältnis von Zr zur Summe Si + Zr, y / (x + y), das durch Integrieren dieser Werte zwischen 25,0 % und 40,0 %, durch Integrieren dieser Werte sogar zwischen 26,32 % und 37,5 %, durch Integrieren dieser Werte sogar zwischen 27,0 % und 37,0 %, liegt, umfasst/umfassen.

2. Substrat (30) nach Anspruch 1, ***dadurch gekennzeichnet, dass*** die Schicht (126, 166), umfassend Silicium-Zirkonium-Nitrid, SiₓZr_{y}N_{z}, eine Nitrierung z zwischen 4/3 (x + y) und 5/3 (x + y) durch Integrieren dieser Werte aufweist.

3. Substrat (30) nach Anspruch 1 oder 2, ***dadurch gekennzeichnet, dass*** die Schicht (126, 166), umfassend Silicium-Zirkonium-Nitrid, SiₓZr_{y}N_{z}, keinen Sauerstoff umfasst.

4. Substrat (30) nach einem der Ansprüche 1 bis 3,
***dadurch gekennzeichnet, dass*** die Antireflexbeschichtung (120), die zwischen dem Substrat (30) und der Funktionsschicht (140) angeordnet ist, ferner eine Schicht (122), umfassend Siliciumnitrid ohne Zirkonium, umfasst, wobei die Schicht (122), umfassend Siliciumnitrid ohne Zirkonium, vorzugsweise zwischen dem Substrat (30) und der Schicht (126), umfassend Silicium-Zirkonium-Nitrid, SiₓZr_{y}N_{z}, angeordnet ist.

5. Substrat (30) nach Anspruch 4, ***dadurch gekennzeichnet, dass*** die Schicht (122), umfassend Siliciumnitrid ohne Zirkonium, eine Dicke zwischen 5,0 und 25,0 nm einschließlich dieser Werte aufweist, sogar zwischen 15,0 und 20,0 nm einschließlich dieser Werte.

6. Substrat (30) nach einem der Ansprüche 1 bis 5,
***dadurch gekennzeichnet, dass*** die Antireflexbeschichtung (160), die über der Funktionsschicht (140) gegenüber dem Substrat (30) angeordnet ist, ferner eine Schicht (168), umfassend Siliciumnitrid ohne Zirkonium, umfasst, wobei die Schicht (168), umfassend Siliciumnitrid ohne Zirkonium, vorzugsweise über der Schicht (166), umfassend Silicium-Zirkonium-Nitrid, SiₓZr_{y}N_{z}, angeordnet ist.

7. Substrat (30) nach Anspruch 6, ***dadurch gekennzeichnet, dass*** die Schicht (168), umfassend Siliciumnitrid ohne Zirkonium, eine Dicke zwischen 25,0 nm und 35,0 nm einschließlich dieser Werte aufweist.

8. Substrat (30) nach einem der Ansprüche 1 bis 7,
***dadurch gekennzeichnet, dass*** die Antireflexbeschichtung (160), die über der Funktionsschicht (140) und gegenüber dem Substrat (30) angeordnet ist, ferner eine Schicht (169) in einem dielektrischen Material mit niedrigem Index, insbesondere auf Basis von Siliciumoxid, umfasst.

9. Substrat (30) nach einem der Ansprüche 1 bis 8,
***dadurch gekennzeichnet, dass*** eine Schicht auf Basis von Zinkoxid unter und in Kontakt mit der Funktionsschicht (140) angeordnet ist.

10. Substrat (30) nach einem der Ansprüche 1 bis 9,
***dadurch gekennzeichnet, dass*** die Schicht (126), umfassend Silicium-Zirkonium-Nitrid, SiₓZr_{y}N_{z}, die zwischen dem Substrat (30) und der Funktionsschicht (140) angeordnet ist, eine Dicke zwischen 10,0 und 30,0 nm einschließlich dieser Werte aufweist.

11. Substrat (30) nach einem der Ansprüche 1 bis 10,
***dadurch gekennzeichnet, dass*** die Schicht (166), umfassend Silicium-Zirkonium-Nitrid, SiₓZr_{y}N_{z}, die über der Funktionsschicht (140) gegenüber dem Substrat (30) angeordnet ist, eine Dicke zwischen 6,0 und 12,0 nm einschließlich dieser Werte aufweist.

12. Verglasung (100), die mindestens ein Substrat (30) nach einem der Ansprüche 1 bis 11 enthält, optional mindestens einem anderen Substrat zugeordnet.

13. Verglasung (100) nach Anspruch 12, montiert in monolithischer oder Mehrfachverglasung vom Typ Doppelverglasung oder Dreifachverglasung oder Verbundverglasung, ***dadurch gekennzeichnet, dass*** mindestens das Trägersubstrat des Stapels gewölbt und/oder vorgespannt ist.

14. Verwendung des Substrats nach einem der Ansprüche 1 bis 11 zum Umsetzen einer transparenten Elektrode einer Heizverglasung oder einer elektrochromen Verglasung oder einer Beleuchtungsvorrichtung oder einer Visualisierungsvorrichtung oder einer Photovoltaikplatte.

15. Verfahren zum Herstellen des Substrats nach einem der Ansprüche 1 bis 11, wobei die Schicht (126, 166), umfassend Silicium-Zirkonium-Nitrid, SiₓZr_{y}N_{z}, durch Zerstäubung, in einer stickstoffhaltigen Atmosphäre, eines Ziels, umfassend ein Atomverhältnis von Zr zur Summe Si + Zr, y / (x + y), das durch Integrieren dieser Werte zwischen 25,0 % und 40,0 %, durch Integrieren dieser Werte sogar zwischen 26,32 % und 37,5 %, durch Integrieren dieser Werte sogar zwischen 27,0 % und 37,0 %, liegt, hergestellt wird.

16. Verfahren nach Anspruch 15, **dadurch gekennzeichnet, dass** die Atmosphäre keinen Sauerstoff enthält.

17. Ziel zur Durchführung des Verfahrens nach Anspruch 15 oder 16, umfassend ein Atomverhältnis von Zr zur Summe Si + Zr, y / (x + y), das durch Integrieren dieser Werte zwischen 25,0 % und 40,0 %, durch Integrieren dieser Werte sogar zwischen 26,32 % und 37,5 %, durch Integrieren dieser Werte sogar zwischen 27,0 % und 37,0 %, liegt.

## Claims

1. A transparent substrate (30) provided on a main face with a stack of thin layers comprising a single metallic functional layer (140) having properties of reflection in the infrared region and/or in the solar radiation region, in particular based on silver or on silver-containing metal alloy, and two antireflective coatings (120, 160), said antireflective coatings each comprising at least one dielectric layer (122, 128; 162, 168), said functional layer (140) being positioned between the two antireflective coatings (120, 160), ***characterized in that*** at least the antireflective coating (120) located between said substrate (30) and said functional layer (140), indeed even both antireflective coatings (120, 160), comprise(s) a layer (126, 166) comprising silicon-zirconium nitride, SiₓZr_{y}N_{z}, with an atomic ratio of Zr to the sum Si + Zr, y/(x + y), which is between 25.0% and 40.0%, these values being incorporated, indeed even 26.32% and 37.5%, these values being incorporated, indeed even between 27.0% and 37.0%, these values being incorporated.

2. The substrate (30) as claimed in claim 1, ***characterized in that*** said layer (126, 166) comprising silicon-zirconium nitride, SiₓZr_{y}N_{z}, exhibits a nitridation z of between 4/3(x + y) and 5/3(x + y), these values being incorporated.

3. The substrate (30) as claimed in claim 1 or 2, ***characterized in that*** said layer (126, 166) comprising silicon-zirconium nitride, SiₓZr_{y}N_{z}, does not comprise oxygen.

4. The substrate (30) as claimed in any one of claims 1 to 3, ***characterized in that*** the antireflective coating (120) located between said substrate (30) and said functional layer (140) additionally comprises a layer (122) comprising zirconium-free silicon nitride, said layer (122) comprising zirconium-free silicon nitride preferably being located between said substrate (30) and said layer (126) comprising silicon-zirconium nitride, SiₓZr_{y}N_{z}.

5. The substrate (30) as claimed in claim 4, ***characterized in that*** said layer (122) comprising zirconium-free silicon nitride exhibits a thickness of between 5.0 and 25.0 nm, these values being included, indeed even between 15.0 and 20.0 nm, these values being included.

6. The substrate (30) as claimed in any one of claims 1 to 5, ***characterized in that*** the antireflective coating (160) located above said functional layer (140) on the opposite side from said substrate (30) additionally comprises a layer (168) comprising zirconium-free silicon nitride, said layer (168) comprising zirconium-free silicon nitride preferably being located above said layer (166) comprising silicon-zirconium nitride, SiₓZr_{y}N_{z}.

7. The substrate (30) as claimed in claim 6, ***characterized in that*** said layer (168) comprising zirconium-free silicon nitride exhibits a thickness of between 25.0 and 35.0 nm, these values being included.

8. The substrate (30) as claimed in any one of claims 1 to 7, ***characterized in that*** the antireflective coating (160) located above said functional layer (140) and on the opposite side from said substrate (30) additionally comprises a layer (169) made of a dielectric material having a low index, in particular based on silicon oxide.

9. The substrate (30) as claimed in any one of claims 1 to 8, ***characterized in that*** a layer based on zinc oxide is located below and in contact with said functional layer (140).

10. The substrate (30) as claimed in any one of claims 1 to 9, ***characterized in that*** said layer (126) comprising silicon-zirconium nitride, SiₓZr_{y}N_{z}, which is located between said substrate (30) and said functional layer (140), exhibits a thickness of between 10.0 and 30.0 nm, these values being included.

11. The substrate (30) as claimed in any one of claims 1 to 10, ***characterized in that*** said layer (166) comprising silicon-zirconium nitride, SiₓZr_{y}N_{z}, which is located above said functional layer (140) on the opposite side from said substrate (30), exhibits a thickness of between 6.0 and 12.0 nm, these values being included.

12. A glazing (100) incorporating at least one substrate (30) as claimed in any one of claims 1 to 11, optionally in combination with at least one other substrate.

13. The glazing (100) as claimed in claim 12, mounted as a monolithic unit or as a multiple glazing unit of the double glazing or triple glazing or laminated glazing type, ***characterized in that*** at least the substrate carrying the stack is bent and/or tempered.

14. The use of the substrate as claimed in any one of claims 1 to 11, for producing a transparent electrode of a heated glazing or of an electrochromic glazing or of a lighting device or of a display device or of a photovoltaic panel.

15. A process for the manufacture of the substrate as claimed in any one of claims 1 to 11, in which said layer (126, 166) comprising silicon-zirconium nitride, SiₓZr_{y}N_{z}, is manufactured by sputtering, in a nitrogen-comprising atmosphere, a target comprising an atomic ratio of Zr to the sum Si + Zr, y/(x + y), which is between 25.0% and 40.0%, these values being incorporated, indeed even 26.32% and 37.5%, these values being incorporated, indeed even between 27.0% and 37.0%, these values being incorporated.

16. The process as claimed in claim 15, **characterized in that** said atmosphere does not comprise oxygen.

17. A target for the implementation of the process as claimed in claim 15 or claim 16, comprising an atomic ratio of Zr to the sum Si + Zr, y/(x + y), which is between 25.0% and 40.0%, these values being incorporated, indeed even 26.32% and 37.5%, these values being incorporated, indeed even between 27.0% and 37.0%, these values being incorporated.
